# EUROPEAN PATENT SPECIFICATION

(11) **EP 0 375 193 B1**
(45) Date of publication and mention of the grant of the patent: **16.08.1995**
(21) Application number: 89312591.4
(22) Date of filing: 01.12.1989
(51) Int. Cl.: H03K 3/037

(54) **High accuracy comparator circuit**
Komparatorschaltung hoher Genauigkeit
Circuit comparateur à haute précision

(30) Priority: 19.12.1988 US 286206
(43) Date of publication of application: 27.06.1990
(73) Proprietor: ADVANCED MICRO DEVICES, INC., Sunnyvale, CA 94088-3453 (US)
(72) Inventor: Moyal, Miki Zvi, Austin Texas 78731 (US); Feemster, Ryan Ervin, Austin Texas 78709 (US)
(74) Representative: Sanders, Peter Colin Christopher

(56) References cited:
- EP-A- 0 363 332
- PATENT ABSTRACTS OF JAPAN vol. 8, no. 281 (E-286)(1718) 21 December 1984 & JP-A-59 148 425
- IBM TECHNICAL DISCLOSURE BULLETIN, vol. 27, no. 12, May 1985, New York, US, pp. 7134-7135; "CMOS DELAY CIRCUIT"

## Description

The invention relates to comparator circuit for comparing different voltage signals and providing a digital output, and more particularly to a method and new circuit for providing greater accuracy in comparing the differential voltage signals.

It sometimes becomes a problem to compare differential voltage signals of small differential value when utilizing latching comparator circuits. The problem arises when high impedance nodes are latched to provide a comparison signal. The opening of the latching switch introduces noise from the switch together with mismatched capacitance, and parasitics due to process variations. This noise can be sufficiently large to distort the differential signals. This distortion can result in an output with an opposite value.

JP-A-59148425 discloses a known level comparator of the above-mentioned type which suffers from the problems of parasitic noise.

The present invention seeks to eliminate the aforementioned problem.

The present invention provides a latching comparator comprising: an amplifying stage having a positive input and a negative input (12) for introducing differential voltage signals for comparison, and having inverted and non-inverted outputs constituting a first pair of nodes for receiving amplified differential voltage input signals; an output (13) for providing a comparison signal representative of a one or a zero value; an amplifying and latching stage having inputs connected to the first pair of nodes and outputs connected to a second pair of nodes, which second pair of nodes are operatively connected to said positive and negative inputs of said amplifying stage, said second pair of nodes receiving amplified differential voltage signals at a higher gain than said first pair of nodes which amplified differential voltage signals are fed back to the amplifying stage, the amplifying and latching stage having a first switch operatively connected to said first pair of nodes and said output, and a second switch operatively connected to said second pair of nodes and said output; characterised by clocking means operatively connected to said first and second switches for providing a pair of clocking signals to successively open said switches, said second switch being opened after said first switch, whereby an impedance mismatch at said first pair of nodes due to noise introduced by said first switch will have stabilized by the time said second switch is opened.

Preferably, a delay of between 15 and 25 nanoseconds is provided between the first and second latching switches.

The delay allows for the stabilization of any impedance mismatched parasitics due to noise at the first pair of nodes introduced by opening the first latching switch.

Preferably, the output connected to the latching stage provides a 5 volt (Vcc) signal representing a digital one, or a zero volt signal.

There is therefore provided an improved latching comparator circuit of greater accuracy.

In the accompanying drawings, by way of example only:

FIGURE 1 illustrates a latching comparator circuit containing the invention which provides a second clock signal that stabilizes the impressed differential voltage signal.

FIGURE 2 shows typical timing and cycle diagrams for the latching comparator circuit of FIGURE 1, overcoming an error that can be introduced during switching.

Generally speaking, the invention pertains to a latching comparator circuit and method wherein accuracy is improved by assuring that differential voltage signals of even small value will be precisely latched.

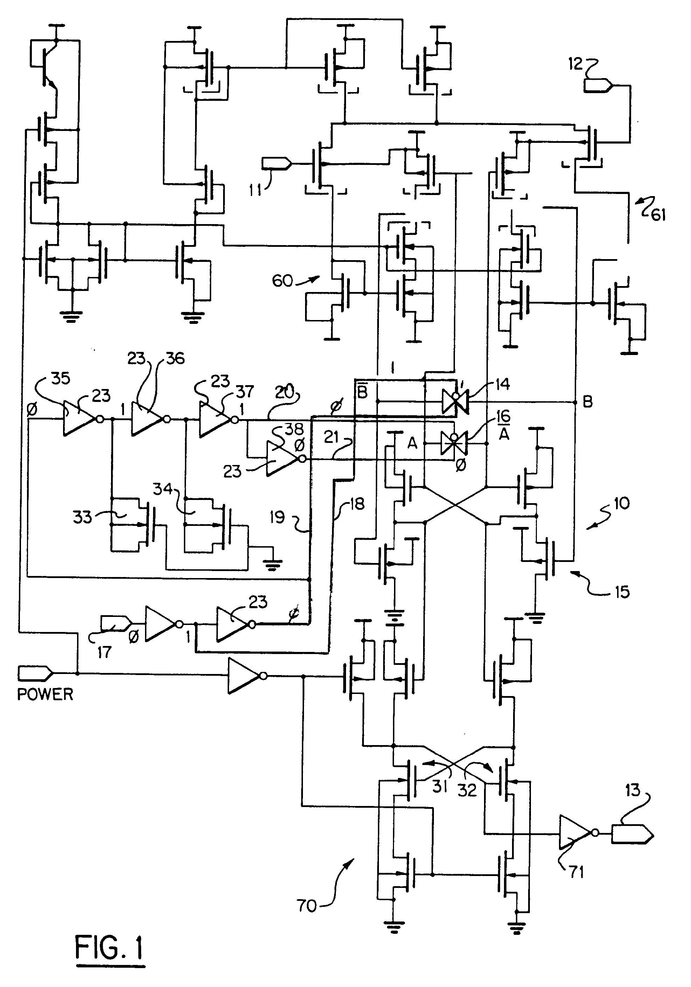

Now referring to FIGURE 1, a latching comparator circuit 10 is shown. Differential voltage signals are introduced to circuit 10 at positive input 11 and negative input 12. The voltage signals are amplified by a number of amplification stages to provide a set of differential signals at nodes A; A̅ and B; B̅, respectively. The nodes B; B̅ are at high impedance. Should a low voltage differential signal be impressed thereon, say on the order of 0.0001 volt, a problem is introduced in obtaining an accurate digital signal at output 13, as will be explained hereinafter.

Nodes B; B̅ are shorted by a switch 14 which forms part of a latching stage 15 which passes the comparison signal to output 13.

Likewise nodes A; A̅ are shorted by a switch 16 which forms part of the latching stage 15.

When switches 14 and 16 are opened, the latching stage 15 will pass a comparison signal to the output 13 via final latching stage 70 and invertor 71.

Switches 14 and 16 comprise p-channel and n-channel, pass-gates, respectively, that require opposite voltages for them to open or close. They form a bridge network. They are controlled by a clock 17, which opens switch 14 by feeding a positive "1" on line 18 and a negative "0" signal on line 19.

Likewise switch 16 is opened when clock 17 feeds a positive "1" signal on line 20 and a negative "0" signal on line 21.

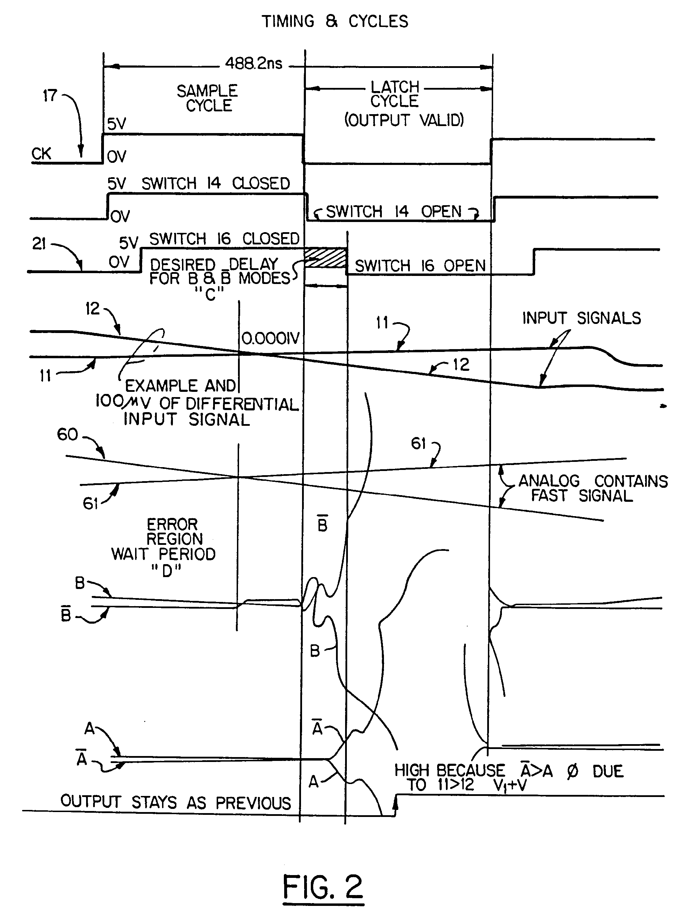

If both switch 14 and switch 16 were opened simultaneously, as has been done in the past, a false comparison signal could be obtained at output 13. This is so because the low voltage differential signal at high impedance nodes B; B̅ could be distorted by the mismatched capacitive effect provided by switch 14, when it opens. In other words, a signal error, as shown in FIGURE 2, could occur due to the "noise" introduced by switch 14.

A small positive differential signal of 0.0001 volt may be seen as a negative voltage at this instant in time, due to the capacitive effect of opening switch 14.

In order to provide a solution to this potential problem, and assure a greater accuracy for circuit 10, the invention introduces a delay of approximately 15 to 25 nanoseconds in the opening of switch 16.

The added delay 'C", as illustrated in FIGURE 2, is provided in lines 20 and 21 controlling switch 16 by inverters 23.

By delaying the opening of switch 16, and consequently the operation of latching stage 15, the instability evident at nodes B; B̅ (error regions "D") after the opening of switch 14 is allowed to settle, causing the signals to be sampled at a higher differential value.

By opening switch 16 subsequent to switch 14, any potential capacitive effects have stabilized at nodes B; B̅.

Nodes A; A̅ see a larger, stable difference due a 500 to 1,000 times gain from the input, by the introduction of delay "C".

The output 13 provides a digital "one" signal of 5 volts and a zero voltage signal.

The final latching stage 70 provides positive feed-back at transistors 31 and 32. The invertor 71 provides additional gain to restore the output. Transistors 31 and 32 act like capacitors together with inverters 35, 36, 37 and 38 to delay the clock signal for switch 16.

## Claims

1. A latching comparator (10) comprising:
an amplifying stage (11,12, 60, 61) having a positive input (11) and a negative input (12) for introducing differential voltage signals for comparison, and having inverted and non-inverted outputs (B,B̅) constituting a first pair of nodes for receiving amplified differential voltage input signals;
an output (13) for providing a comparison signal representative of a one or a zero value;
an amplifying and latching stage (15) having inputs connected to the first pair of nodes (B,B̅) and outputs connected to a second pair of nodes (A,A̅), which second pair of nodes are operatively connected to said positive and negative inputs (11,12) of said amplifying stage, said second pair of nodes (A,A̅) receiving amplified differential voltage signals at a higher gain than said first pair of nodes (B,B̅) which amplified differential voltage signals are fed back to the first amplifying stage,
the amplifying and latching stage (15) having a first switch (14) operatively connected to said first pair of nodes (B,B̅) and said output (13), and a second switch (16) operatively connected to said second pair of nodes (A,A̅) and said output (13);
characterised by clocking means (17) operatively connected to said first and second switches (14,16) for providing a pair of clocking signals to successively open said switches (14,16), said second switch (16) being opened after said first switch (14), whereby an impedance mismatch at said first pair of nodes (B,B̅) due to noise introduced by said first switch (14) will have stabilized by the time said second switch (16) is opened.

2. A latching comparator as claimed in claim 1, wherein said clocking means (17) further includes delay means (31,32,35,36,37,38) for providing a clocking signal to said second switch (16), 15 to 25 nanoseconds after said first switch (14).

3. A latching comparator circuit as claimed in claim 1 or claim 2, wherein said first and second switches (14,16) form a bridge network.

4. A latching comparator as claimed in claim 1, 2 or 3, wherein said second switch signal is delayed by a number of inverters (39,36,37,38) from the first switch signal.

5. The latching comparator circuit as claimed in any preceding claim, wherein said output (13) provides a comparison signal of approximately 5 volts representing a one value.

6. A method of comparing differential voltage signals, comprising the steps of:
(a) introducing said differential voltage signals to respective positive and negative inputs (11,12) of an amplifying stage (11,12,60,61), said amplifying stage having inverted and non-inverted outputs (B,B̅) constituting a first pair of nodes which receive the amplified differential voltage signals;
(b) introducing said amplified differential voltage signals to a second pair of nodes (A,A̅) at the output of an amplifying and latching stage, which second pair of nodes are operatively connected to said positive and negative inputs (11,12) of said first amplifying stage, said second pair of nodes (A,A̅) receiving amplified differential voltage signals at a higher gain than said first pair of nodes (B,B̅);
(c) feeding back the voltage signals at the second pair of nodes (A,A̅) to the first amplifying stage;
(d) opening a first latching switch disposed between said first pair of nodes (B,B̅) to provide a latching signal; and characterised by
(e) opening a second latching switch (16) disposed between said second pair of nodes (A,A̅) to provide a latching signal, said second switch (16) being opened subsequent to said first switch (14) whereby an impedance mismatch at the first pair of nodes (B,B̅) due to noise introduced by opening said first switch (14) will have stabilized by the time said second switch (16) is opened.

7. A method as claimed in claim 6, wherein said second switch (16) is opened 15 to 25 nanoseconds after said first switch (14).

## Patentansprüche

1. Haltekomparator (10), mit:
einer Verstärkungsstufe (11,12,60,61) mit einem positiven Eingang (11) und einem negativen Eingang (12) zum Einführen von Differenzspannungssignalen zum Vergleich, und mit invertierten und nicht-invertierten Ausgängen (B,B̅), die zwei erste Schaltungspunkte zum Empfang verstärkter Differenzspannungseingangssignale bilden,
einem Ausgang (13) zum Liefern eines einen Eins- oder einen Null-Wert repräsentierenden Vergleichssignals,
einer Verstärkungs- und Haltestufe (15) mit Eingängen, die mit den beiden ersten Schaltungspunkten (B,B̅) verbunden sind, und Ausgängen, die mit zwei zweiten Schaltungspunkten (A,A̅) verbunden sind, wobei die beiden zweiten Schaltungspunkte mit den positiven und negativen Eingängen (11,12) der ersten Verstärkungsstufe operativ verbunden sind, die beiden zweiten Schaltungspunkte (A,A̅) verstärkte Differenzspannungssignale mit einer höheren Verstärkung als die beiden ersten Schaltungspunkte empfangen und wobei die verstärkten Differenzspannungssignale zu der ersten Verstärkungsstufe zurückgeführt werden,
wobei die Verstärkungs- und Haltestufe (15) einen operativ mit den beiden ersten Schaltungspunkten (B,B̅) und dem Ausgang (13) verbundenen ersten Schalter (14) und einen operativ mit den beiden zweiten Schaltungspunkten (A,A̅) und dem Ausgang (13) verbundenen zweiten Schalter (16) aufweist,
gekennzeichnet durch eine Takteinrichtung (17), die mit den ersten und zweiten Schaltern (14,16) zur Lieferung eines Paares von Taktsignalen zum sukzessiven Öffnen der Schalter (14,16) operativ verbunden ist, wobei der zweite Schalter (16) nach dem ersten Schalter (14) geöffnet wird, wodurch sich eine Impedanzfehlanpassung an den beiden ersten Schaltungspunkten (B,B̅), welche auf von dem ersten Schalter (14) eingebrachtes Rauschen zurückzuführen ist, bis zum Öffnen des zweiten Schalters (16) stabilisiert haben wird.

2. Haltekomparator nach Anspruch 1, bei dem die Takteinrichtung (17) ferner eine Verzögerungseinrichtung (31,32,35,36,37,38) aufweist, um dem zweiten Schalter (16) 15 bis 25 Nanosekunden nach dem ersten Schalter (14) ein Taktsignal zuzuführen.

3. Haltekomparatorschaltung nach Anspruch 1 oder Anspruch 2, bei der die ersten und zweiten Schalter (14,16) ein Brükkennetzwerk bilden.

4. Haltekomparator nach Anspruch 1, 2 oder 3, bei dem das zweite Schaltersignal von einer Anzahl von Invertern (39,36,37,38) gegenüber dem ersten Schaltersignal verzögert wird.

5. Haltekomparatorschaltung nach einem der vorhergehenden Ansprüche, bei der der Ausgang (13) ein Vergleichssignal von ungefähr 5 Volt liefert, das einen Eins-Wert darstellt.

6. Verfahren zum Vergleichen von Differenzspannungssignalen, mit den Schritten:
(a) Einführen der Differenzspannungssignale zu jeweiligen positiven und negativen Eingängen (11,12) einer Verstärkungsstufe (11,12,60,61), wobei die Verstärkungsstufe invertierte und nicht-invertierte Ausgänge (B,B̅) aufweist, welche zwei erste Schaltungspunkte bilden, die die verstärkten Differenzspannungssignale empfangen,
(b) Einführen der verstärkten Differenzspannungssignale zu zwei zweiten Schaltungspunkten (A,A̅) am Ausgang einer Verstärkungs- und Haltestufe, wobei die beiden zweiten Schaltungspunkte operativ mit den positiven und negativen Eingängen (11,12) der ersten Verstärkungsstufe verbunden sind, wobei die beiden zweiten Schaltungspunkte (A,A̅) verstärkte Differenzspannungssignale mit einer höheren Verstärkung empfangen als die beiden ersten Schaltungspunkte (B,B̅),
(c) Rückführen der Spannungssignale der beiden zweiten Schaltungspunkte (A,A̅) zu der ersten Verstärkungsstufe,
(d) Öffnen eines zwischen den beiden ersten Schaltungspunkten (B,B̅) angeordneten ersten Halteschalters zum Liefern eines Haltesignals, und gekennzeichnet durch
(e) Öffnen eines zwischen den beiden zweiten Schaltungspunkten (A,A̅) angeordneten zweiten Halteschalters (16) zum Liefern eines Haltesignals, wobei der zweite Schalter (16) im Anschluß an den ersten Schalter (14) geöffnet wird, wodurch sich eine Impedanzfehlanpassung an den beiden ersten Schaltungspunkten (B,B̅), die auf durch Öffnen des ersten Schalters (14) eingebrachtes Rauschen zurückzuführen ist, bis zum Öffnen des zweiten Schalters (16) stabilisiert haben wird.

7. Verfahren nach Anspruch 6, bei dem der zweite Schalter (16) 15 bis 25 Nanosekunden nach dem ersten Schalter (14) geöffnet wird.

## Revendications

1. Comparateur à verrouillage (10) comportant:
un étage d'amplification (11, 12, 60, 61) ayant une entrée positive (11) et une entrée négative (12) pour appliquer des signaux différentiels de tension en vue d'une comparaison, et ayant des sorties inversée et non-inversée (B, B̅) qui constituent une première paire de noeuds de réception de signaux différentiels d'entrée amplifiés;
une sortie (13) pour fournir un signal de comparaison représentatif de la valeur un ou zéro;
un étage d'amplification et de verrouillage (15) ayant des entrées connectées à la première paire de noeuds (B, B̅) et des sorties connectées à une seconde paire de noeuds (A,A̅), laquelle seconde paire de noeuds est fonctionnellement connectée auxdites entrées positive et négative (11, 12) dudit étage d'amplification, ladite seconde paire de noeuds (A, A̅) recevant des signaux différentiels de tension amplifiés avec un gain plus élevé que ladite première paire de noeuds (B, B̅), lesdits signaux différentiels de tension amplifiés étant réinjectés dans le premier étage d'amplification,
l'étage d'amplification et de verrouillage (15) ayant un premier interrupteur (14) fonctionnellement connecté à ladite première paire de noeuds (B, B̅) et à ladite sortie (13), et un second interrupteur (16) fonctionnellement connecté à ladite seconde paire de noeuds (A, A̅) et à ladite sortie (13);
caractérisé par un moyen d'horloge (17) fonctionnellement connecté auxdits premier et second interrupteurs (14, 16) pour fournir une paire de signaux d'horloge auxdits interrupteurs (14, 16) successivement ouverts, ledit second interrupteur (16) étant ouvert après ledit premier interrupteur (14) ce par quoi, un défaut d'adaptation d'impédance au niveau de la première paire de noeuds (B, B̅), dû au bruit introduit par ledit premier interrupteur (14), aura été stabilisé au moment de l'ouverture dudit second interrupteur (16).

2. Comparateur à verrouillage selon la revendication 1, dans lequel ledit moyen d'horloge (17) comprend en outre un moyen de temporisation (31, 32, 35, 36, 37, 38) pour fournir un signal d'horloge audit second interrupteur (16) 15 à 25 nanosecondes après ledit premier interrupteur (14).

3. Comparateur à verrouillage selon la revendication 1 ou la revendication 2, dans lequel lesdits premier et second interrupteurs (14, 16) constituent un montage en pont.

4. Comparateur à verrouillage selon la revendication 1, 2 ou 3, dans lequel ledit second signal d'interrupteur est retardé par rapport au premier signal d'interrupteur par un certain nombre d'inverseurs (39, 36, 37, 38).

5. Comparateur à verrouillage selon l'une quelconque des revendications précédentes, dans lequel ladite sortie (13) fournit un signal de comparaison d'environ 5 volts représentant la valeur un.

6. Procédé de comparaison de signaux différentiels de tension, comportant les étapes:
(a) d'application desdits signaux différentiels de tension respectivement aux entrées positive et négative (11, 12) d'un étage d'amplification (11, 12, 60, 61), ledit étage d'amplification ayant des sorties inversée et non-inversée (B, B̅) qui constituent une première paire de noeuds de réception des signaux différentiels de tension amplifiés;
(b) d'application desdits signaux différentiels de tension à une seconde paire de noeuds (A, A̅) à la sortie d'un étage d'amplification et de verrouillage, laquelle seconde paire de noeuds est fonctionnellement connectée auxdites entrées positive et négative (11, 12) dudit étage d'amplification, ladite seconde paire de noeuds (A, A̅) recevant des signaux différentiels de tension amplifiés avec un gain plus élevé que ladite première paire de noeuds (B, B̅);
(c) de réinjection dans le premier étage d'amplification des signaux de tension présents au niveau de la seconde paire de noeuds (A, A̅);
(d) d'ouverture d'un premier interrupteur de verrouillage placé entre les noeuds de ladite première paire de noeuds (B, B̅) pour fournir un signal de verrouillage; et caractérisé par l'étape:
(e) d'ouverture d'un second interrupteur de verrouillage (16) placé entre les noeuds de ladite seconde paire de noeuds (A, A̅) pour fournir un signal de verrouillage, ledit second interrupteur (16) étant ouvert après ledit premier interrupteur (14); par ce fait, un défaut d'adaptation d'impédance au niveau de la première paire de noeuds (B, B̅), dû au bruit introduit par ledit premier interrupteur (14), aura été stabilisé au moment de l'ouverture dudit second interrupteur (16).

7. Procédé selon la revendication 6, dans lequel ledit second interrupteur (16) est ouvert 15 à 25 nanosecondes après ledit premier interrupteur (14).
